# EUROPÄISCHE PATENTSCHRIFT

(11) **EP 1 327 519 B1**
(45) Veröffentlichungstag und Bekanntmachung des Hinweises auf die Patenterteilung: **21.06.2006**
(21) Anmeldenummer: 02026025.3
(22) Anmeldetag: 21.11.2002
(51) Int. Cl.: B32B 38/00, B32B 37/10, H01L 21/00

(54) **Vorrichtung und Verfahren zum flächigen Zusammendrücken zu verbindender scheibenförmiger Elemente**
Apparatus and method for pressing together disc-shaped elements to be bonded
Appareil et procédé pour presser ensemble des éléments en forme de disque à assembler

(30) Priorität: 09.01.2002 DE 10200538
(43) Veröffentlichungstag der Anmeldung: 16.07.2003
(73) Patentinhaber: Infineon Technologies AG, 81669 München (DE)
(72) Erfinder: Kröner, Friedrich, 9500 Villach (AT)
(74) Vertreter: Kindermann, Peter

(56) Entgegenhaltungen:
- EP-A- 0 038 922
- AT-B- 405 700
- US-A- 4 273 604
- US-A- 5 589 016
- US-A- 6 146 578
- US-B1- 6 217 695
- US-B1- 6 481 482

## Beschreibung

Die vorliegende Erfindung bezieht sich auf eine Vorrichtung und ein Verfahren zum flächigen Zusammendrücken zu verbindender scheibenförmiger Elemente und insbesondere von zu verbindenden Halbleiterwafern.

Aus der Druckschrift US-A-6 146 578 ist eine Vorrichtung zum flächigen Zusammendrücken zu verbindender Elemente mit einer zwei Membranschichten aufweisenden Druckkammer bekannt, die einen Hohlraum zum Aufnehmen der Elemente und ein Anschlusssystem zum Evakuieren des Hohlraums aufweist, wobei mittels eines Flüssigkeiten-Heizsystems die Elemente erwärmt werden.

Bei der Herstellung von Halbleiterbauelementen besteht oftmals die Notwendigkeit scheibenförmige Elemente wie beispielsweise Halbleiterwafer kurzzeitig oder für immer miteinander zu verbinden. Ein derartiges Verbinden ist beispielsweise bei der Handhabung und Herstellung von ultradünnen Halbleiterscheiben bzw. -wafern oder einer abschließenden Goldkontaktierung notwendig.

Diese herkömmliche, auch als Bonden bezeichnete Verbindungstechnik kennt Verbindungsverfahren ohne Zwischenschicht (z.B. anodisches Bonden) oder Verbindungen mit Klebern, Spin-on-Glas oder schmelzenden Metallen. Je nach verwendetem Bondprozess sind Temperaturen von Zimmertemperatur bis über 440 Grad Celsius notwendig, wobei auf die beiden scheibenförmigen Elemente ein gleichmäßiger Druck von einigen Hundertstel einer Atmosphäre bis über einer Atmosphäre ausgeübt werden muss.

In der Druckschrift AT70798 ist eine herkömmliche Vorrichtung und ein zugehöriges Verfahren zum flächigen Zusammendrücken zu verbindender scheibenförmiger Elemente am Beispiel des Verfahrens zum eutektischen Gold-Bonden näher beschrieben. Hierbei werden üblicherweise Temperaturen von 400 Grad Celsius bei einem Druck größer einer Atmosphäre benötigt, wobei zwischen den beiden zu verbindenden Wafern ein Hochvakuum erzeugt wird. Zur Realisierung dieses Bondprozesses wird eine widerstandsbeheizte Bondkammer mit einem hydraulischen Stempel verwendet, wobei eine dünne Quarzplatte und ein darüber angeordnetes Sintermaterial aus Graphitkörnchen für eine gleichmäßige Druckverteilung sorgen. Nachteilig ist jedoch bei dieser herkömmlichen Vorrichtung und dem zugehörigen Verfahren, dass auf Grund der thermischen Trägheit der gesamten Anordnung und der notwendigen Bedingung, dass eine Temperaturdifferenz innerhalb des Wafers wesentlich unterhalb von 10 Kelvin gehalten werden muss, ein derartiger Bondprozess üblicherweise sehr lange, d.h. eine halbe Stunde oder länger, dauert.

Für eine Wirtschaftlichkeit des Verfahrens ist jedoch nicht nur die exakte Einhaltung der thermodynamischen Parameter Druck und Temperatur erforderlich, sondern auch der Durchsatz in der Produktion von Bedeutung.

Der Erfindung liegt daher die Aufgabe zu Grunde eine Vorrichtung und ein Verfahren zum flächigen Zusammendrücken zu verbindender scheibenförmiger Elemente zu schaffen, wobei eine Produktivität wesentlich verbessert ist.

Erfindungsgemäß wird diese Aufgabe hinsichtlich der Vorrichtung durch die Merkmale des Patentanspruchs 1 und hinsichtlich des Verfahrens durch die Maßnahmen des Patentanspruchs 13 gelöst.

Insbesondere durch die Verwendung einer zwei Membranschichten aufweisenden Druckkammer, die einen Hohlraum zum Aufnehmen der scheibenförmigen Elemente ausbilden, welcher evakuierbar ist, und einem Heizsystem zum Erwärmen der scheibenförmigen Elemente mittels Heizstrahlung, wobei die Membranschichten ein elastisch verformbares Material mit derart hoher Wärmeleitfähigkeit und hoher Oberflächen-Spektralselektivität aufweisen, dass mehr als 90% der Heizstrahlungsleistung absorbiert wird, kann die Prozessdauer eines derartigen Waferbonds bzw. Verbindungsverfahrens erheblich verkürzt werden.

Die Membranschichten können hierbei aus einer alleinigen metallischen Schicht oder eine Kombination der metallischen Schicht mit einer Membran realisiert werden, wodurch die schwer zu vereinbarenden Anforderungen hinsichtlich der elastischen Verformbarkeit, der hohen Wärmeleitfähigkeit und der hohen Oberflächen-Spektralselektivität auf besonders einfache und kostengunstige Art und Weise realisiert werden können.

Vorzugsweise besteht die Membran aus gesinterten Graphitteilchen, aus Quarz- oder Glasfasern oder einem Gemisch aus Graphit- und Quarzteilchen, wodurch man eine besonders gleichmä-βige Druckverteilung auf die zu verbindenden scheibenförmigen Elemente erhält.

Vorzugsweise besteht die Membran aus einem Material mit ähnlichem, thermischem Ausdehnungskoeffizienten wie das der scheibenförmigen Elemente, wodurch insbesondere temperaturbedingte mechanische Spannungen verhindert werden.

Als metallische Schicht kann beispielsweise mit Schwarzchrom- oder Titan-Nitrid-Oxid beschichtetes Kupfer oder ein schwarzchrom-beschichteter Edelstahl verwendet werden, wodurch man eine hervorragende Oberflächen-Spektralselektivität insbesondere bei sichtbarem Licht und eine hohe Wärmeleitfähigkeit erhält. Sowohl eine gleichmäßige Temperaturverteilung als auch ein sehr schneller Aufheizvorgang können dadurch realisiert werden.

Das Heizsystem besitzt vorzugsweise eine Vielzahl von regelbaren Heizlampen und zugehörigen Reflektoren zum Erzeugen von gleichmäßig verteiltem sichtbarem Licht, wodurch insbesondere in Verbindung mit den vorstehend beschriebenen Beschichtungen der metallischen Schicht eine außerordentlich kurze Aufheizzeit ermöglicht wird.

In den weiteren Unteransprüchen sind weitere vorteilhafte Ausgestaltungen der Erfindung gekennzeichnet.

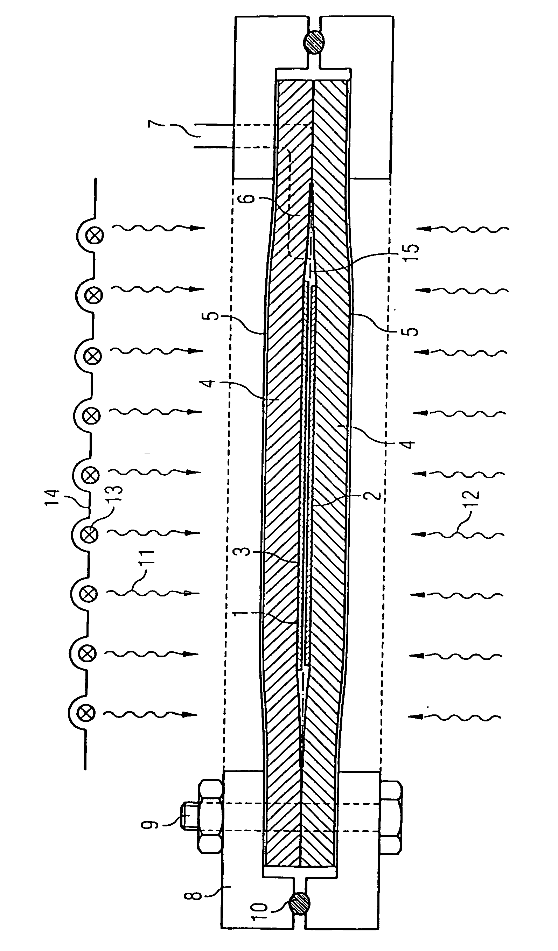

Die Erfindung wird nachstehend anhand eines Ausführungsbeispiels unter Bezugnahme auf die Zeichnung näher beschrieben.

Die Figur zeigt eine vereinfachte Schnittansicht der erfindungsgemäßen Vorrichtung zum Zusammendrücken von scheibenförmigen Elementen.

Gemäß der Figur werden zwei zu verbindende scheibenförmige Elemente 1 und 2, wie z.B. Halbleiterwafer, mit einem Bindemittel 3 zusammengefügt. Das Bindemittel 3 kann hierbei ein sogenanntes Spin-on-Glas oder ein auf einem Metall basierendes Bondingmaterial aufweisen, wie z.B. Silberpaste oder Gold.

Anschließend werden zwei aus einer Membran 4 und einer metallischen Schicht 5 bestehende Membranschichten, die eine größere Fläche aufweisen als die zu verbindenden Elemente bzw. Wafer 1 und 2, an die Wafer 1 und 2 angelegt, wobei ein entstehender Hohlraum 15 über eine als Anschlusssystem bezeichnete Leitung 6 und einen Anschluss 7 mit einer nicht dargestellten Vakuumpumpe verbindbar ist. Auf diese Weise kann der Hohlraum 15 evakuiert werden, wodurch ein Unterdruck im Hohlraum 15 erzeugt wird und die zu verbindenden Wafer 1 und 2 über die Membranen 4 bzw. die metallischen Schichten 5 mit dem außen anliegenden Umgebungsdruck zusammengepresst werden können. Zur verbesserten Handhabung werden gemäß der Figur entlang des Umfanges der Membranen 4 bzw. der metallischen Schichten 5 jeweils ein Ring 8 aufgelegt und mittels eines Verbindungselements 9 und eines Abdichtelements 10 luftdicht verbunden.

Auf diese Weise entsteht eine sehr kostengünstige und leicht bestückbare Druckkammer bzw. Membrandruckkammer. Die Druckkammer kann jedoch alternativ zu dem in der Figur dargestellten Ausführungsbeispiel auch anders ausgestaltet sein, wobei insbesondere der Ring 8, das Verbindungselement 9 und das Abdichtelement 10 auch entfallen können und die Druckkammer ausschließlich aus den Membranen 4 und der metallischen Schicht 5, die gemeinsam die sogenannte Membranschichten bilden, bestehen können.

Anschließend werden die scheibenförmigen Elemente bzw. die Wafer 1 und 2 sowie das eventuell dazwischen liegende Bindemittel 3 über ein Heizstrahlungssystem erwärmt, wobei gleichzeitig oder nachfolgend ein Evakuieren des Hohlraums 15 mittels des Anschlusses 7 und der Leitung 6 durch die nicht dargestellte Vakuumpumpe zum Erzeugen eines Unterdrucks erfolgt. Auf diese Weise werden die Wafer 1 und 2 unter einem vorbestimmten Druck und bei einer vorbestimmten Temperatur zusammengedrückt, wodurch die gewünschte Verbindung realisiert wird.

Das Heizstrahlungssystem besteht vorzugsweise aus einem Lampensystem mit einer Vielzahl von regelbaren Heizlampen 13 zum Erzeugen von Heizstrahlung und insbesondere von gleichmäßig verteiltem sichtbaren Licht 11 und 12. Zur Verbesserung einer Abstrahlung und einer Effektivität kann das Heizsystem ferner ein Reflektorsystem bzw. eine Vielzahl von Reflektoren 14 aufweisen. Ferner ist dadurch eine weitere Vergleichmäßigung des abgestrahlten Lichts bzw. der Heizstrahlung 11 und 12 realisierbar.

Gemäß der Figur wird der gleichmäßige Anpressdruck im Idealfall dadurch gewährleistet, dass der erste Teil der Membranschichten, d.h. die Membran 4, aus einem elastisch verformbaren Material besteht, dessen thermischer Ausdehnungskoeffizient dem der scheibenförmigen Elemente 1 und 2 entspricht, bzw. bei der Herstellung von Halbleiterscheiben üblicherweise dem von Silizium ähnlich ist. Zur Realisierung der Membran 4 kommen daher insbesondere gesinterte Graphitkörnchen oder auch Quarzfaser- bzw. Glasfasermaterialien oder auch ein Gemisch aus beiden in Frage, wodurch sich eine ausreichende Wärmeleitfähigkeit der Membran 4 ergibt und sich ferner deren thermischer Ausdehnungskoeffizient einstellen lässt. Die Dicke dieser Membranen 4 beträgt beispielsweise 1 bis 2 mm.

Da auf Grund der verwendeten Materialien die Membran 4 jedoch porös ist, wird gemäß der Figur zusätzlich eine metallische Schicht 5 darüber angeordnet. Um den weiteren Anforderungen einer schnellen Heizrate und einer gleichmäßigen Temperaturverteilung gerecht zu werden, werden insbesondere metallische Folien ausgewählt, die aus einem hoch wärmeleitfähigen Metall bestehen, und eine Oberfläche mit hoher Spektralselektivität aufweisen.

Unter einem Körper mit hoher Oberflächen-Spektralselektivität bzw. einer spektralselektiven Oberfläche wird hierbei eine Oberfläche verstanden, die mehr als 90 % der Lichtleistung des eingestrahlten Lichts 11 und 12, welches die Wafer 1 und 2 von beiden Seiten bestrahlt, absorbiert. Gleichzeitig betragen jedoch die temperaturbedingten Abstrahlungsverluste dieser Oberfläche nur 10 % oder weniger derjenigen eines schwarzen Körpers, wobei es sich um Abstrahlungsverluste im nicht sichtbaren Bereich handelt. Durch ein derartiges Oberflächenmaterial kann die Gleichmäßigkeit der Temperaturverteilung im Wesentlichen durch die Gleichmäßigkeit der Bestrahlung eingestellt werden und die durch Abstrahlung bedingten Ungleichmäßigkeiten des Wärmeabflusses an die Umgebung bei der Betrachtung einer Gleichmäßigkeit der Temperaturverteilung an den zu verbindenden Wafern 1 und 2 vernachlässigt werden.

Aus diesen Gründen können bei Anwendungen mit geringen Ansprüchen hinsichtlich der Gleichförmigkeit der Temperaturverteilung in den zu verbindenden Wafern 1 und 2 und hinsichtlich der thermischen Spannungen auch die metallischen Schichten 5 alleine als druckerzeugende Membranschichten mit hoher Wärmeleitfähigkeit und Oberflächen-Spektralselektivität bei ausreichender Verformbarkeit verwendet werden.

Zur Realisierung eines gleichmäßig einstrahlenden Lichtes kann beispielsweise auf die bei RTP-Geräten (Rapid Thermal Process) verwendeten Techniken zurückgegriffen werden, wobei ebenfalls regelbare Lampenanordnungen mit Reflektoren verwendet werden. Da Silizium nahezu ideale spektralselektive Eigenschaften aufweist, sind die Anforderungen an die Lampen praktisch dieselben wie bei den RTP-Geräten.

Für die metallische Schicht 5 mit der spektralselektiven Oberfläche kann beispielsweise eine Kupferfolie mit einer schwarzverchromten Oberfläche und einer galvanischen Zwischenschicht aus Nickel verwendet werden. Alternativ kann die Kupferfolie auch mittels eines hochvakuumbedampften Titan-Nitrid-Oxids als spektralselektive Oberfläche beschichtet werden. In beiden Fällen erhält man eine außerordentlich hohe Wärmeleitfähigkeit und Oberflachen-Spektralselektivität, wodurch eine Erwärmung bzw. ein Aufheizen außerordentlich schnell und effektiv realisiert werden kann. Auch eine Schwarzchrom-Beschichtung auf Edelstahl kann für die metallische Schicht 5 verwendet werden, wobei jedoch die Wärmeleitfähigkeit gegenüber dem Kupfer weniger als ein Zehntel beträgt und somit die Anforderungen an die Gleichförmigkeit der Temperaturverteilung durch die Heizstrahlung wie z.B. das gleichmäßig verteilte sichtbare Licht wesentlich höher sind.

Vorzugsweise bestehen die Reflektoren 14 bzw. ein entsprechendes Reflektorsystem aus hochwertigen Reflektoren, beispielsweise aus Gold, wodurch auch eine eventuell ebenfalls vorhandene hohe Emissivitat bzw. Emission der Druckkammer mit ihren Membranschichten keine wesentlichen Ungleichmäßigkeiten in der Temperaturverteilung besitzt. Die Abstrahlungsverluste der Membranschichten 4, 5 werden nämlich durch die Reflektoren 14 gleichmäßig returniert bzw. ruckgestrahlt.

Die Erfindung wurde vorstehend anhand einer Membrandruckkammer mit aus einer elastisch verformbaren Membran 4 und einer metallischen Schicht 5 mit hoher Wärmeleitfähigkeit und hoher Oberflächen-Spektralselektivität bestehenden Membranschichten beschrieben. Sie ist jedoch nicht darauf beschränkt und umfasst in gleicher Weise andere Membranschichten, die beispielsweise die elastische Verformbarkeit, die Wärmeleitfähigkeit und die Spektralselektivität in einem Material vereinen.

Ferner ist für eine erfindungsgemäße Vorrichtung mit sehr gut gleichmäßig arbeitenden Reflektoren eine hohe Absorptivität der metallischen Schicht 5 alleine auch schon ausreichend. Weiterhin wurden vorstehend für die metallische Schicht 5 stark das sichtbare Licht absorbierende und temperaturresistente Beschichtungen von gut leitfähigen Metallen beschrieben. Es sind jedoch auch alle weiteren spektralselektiven Schichten als Oberflächen zu verwenden, die einen schwarzen Körper in allen interessierenden Wellenlängenbereichen darstellen können.

## Patentansprüche

1. Vorrichtung zum flächigen Zusammendrücken zu verbindender Elemente (1, 2) mit
einer zwei Membranschichten (4, 5) aufweisenden Druckkammer, die einen Hohlraum (15) zum Aufnehmen der Elemente (1, 2) und ein Anschlusssystem (6, 7) zum Evakuieren des Hohlraums (15) aufweist; und
einem Heizsystem (13, 14) zum Erwärmen der Elemente (1, 2),
**dadurch gekennzeichnet, dass**
die Elemente (1, 2) scheibenförmig ausgebildet sind,
das Heizsystem ein Heizstrahlungssystem (13, 14) zum Erwärmen der Elemente (1, 2) mittels Heizstrahlung (11, 12) aufweist, und
die zwei Membranschichten (4, 5) ein elastisch verformbares Material mit einer derart hohen Wärmeleitfähigkeit und Oberflächen-Spektralselektivität aufweisen, dass mehr als 90% der Heizstrahlungsleistung absorbiert wird.

2. Vorrichtung nach Patentanspruch 1,
**dadurch gekennzeichnet, dass** die Membranschichten eine metallische Schicht (5) oder eine Kombination einer metallischen Schicht (5) mit einer Membran (4) aufweisen.

3. Vorrichtung nach Patentanspruch 2,
**dadurch gekennzeichnet, dass** die Membran (4) gesinterte Graphitteilchen aufweist.

4. Vorrichtung nach Patentanspruch 2,
**dadurch gekennzeichnet, dass** die Membran (4) Quarz- oder Glasfasern aufweist.

5. Vorrichtung nach Patentanspruch 2,
**dadurch gekennzeichnet, dass** die Membran (4) ein Gemisch aus Graphit- und Quarzteilchen aufweist.

6. Vorrichtung nach einem der Patentansprüche 2 bis 5,
**dadurch gekennzeichnet, dass** die Membran (4) ein dem Material der scheibenförmigen Elemente (1, 2) angepasstes Material mit ähnlichem, thermischem Ausdehnungskoeffizienten aufweist.

7. Vorrichtung nach einem der Patentansprüche 2 bis 6,
**dadurch gekennzeichnet, dass** die metallische Schicht (5) ein schwarzchrom-beschichtetes Kupfer aufweist.

8. Vorrichtung nach einem der Patentansprüche 2 bis 6,
**dadurch gekennzeichnet, dass** die metallische Schicht (5) ein mit Titan-Nitrid-Oxid beschichtetes Kupfer aufweist.

9. Vorrichtung nach einem der Patentansprüche 2 bis 6,
**dadurch gekennzeichnet, dass** die metallische Schicht (5) einen schwarzchrom-beschichteten Edelstahl aufweist.

10. Vorrichtung nach einem der Patentansprüche 1 bis 9,
**dadurch gekennzeichnet, dass** das Heizsystem eine Vielzahl von regelbaren Heizlampen (13) zum Erzeugen von gleichmäßig verteiltem sichtbaren Licht (11, 12) aufweist.

11. Vorrichtung nach Patentanspruch 10,
**dadurch gekennzeichnet, dass** das Heizsystem eine Vielzahl von Reflektoren (14) aufweist.

12. Vorrichtung nach einem der Patentansprüche 1 bis 11,
**dadurch gekennzeichnet, dass** sie zum Erzeugen von weiterhin erhöhten Drücken in einem weiteren Druckgefäß angeordnet ist.

13. Verfahren zum flächigen Zusammendrücken von zu verbindenden scheibenförmigen Elementen mit den Schritten:
a) Vorbereiten einer Druckkammer (4, 5, 8, 9, 10) mit zwei darin angeordneten elastisch verformbaren Membranschichten (4, 5) mit derart hoher Wärmeleitfähigkeit und Oberflächen-Spektralselektivität, dass mehr als 90% der Heizstrahlungsleistung absorbiert wird, die einen Hohlraum (15) ausbilden, der zum Evakuieren an ein Anschlusssystem (6, 7) anschließbar ist;
b) Anordnen der scheibenförmigen Elemente (1, 2) im Hohlraum (15);
c) Erwärmen der scheibenförmigen Elemente (1, 2); und d) Evakuieren des Hohlraums (15) mittels des Anschlusssystems (6, 7) zum Erzeugen eines Unterdrucks und zum Zusammendrücken der scheibenförmigen Elemente (1, 2).

14. Verfahren nach Patentanspruch 13,
**dadurch gekennzeichnet, dass** in Schritt a) als Membranschicht eine metallische Schicht (5) oder eine Kombination einer metallischen Schicht (5) mit einer Membran (4) verwendet wird.

15. Verfahren nach Patentanspruch 13 oder 14,
**dadurch gekennzeichnet, dass** in Schritt c) das Erwärmen der scheibenförmigen Elemente über die Membranschichten (4,5) erfolgt.

16. Verfahren nach einem der Patentansprüche 13 bis 15,
**gekennzeichnet durch** einen Schritt e) Ausbilden eines weitergehenden Außen-Überdrucks für die Druckkammer (4, 5, 8, 9, 10) zum Erzeugen eines weitergehenden Unterdrucks im Hohlraum (15).

## Claims

1. Apparatus for pressing together in planar fashion elements (1, 2) to be bonded, comprising
a pressure chamber having two membrane layers (4, 5), which has a cavity (15) for receiving the elements (1, 2) and a connection system (6, 7) for evacuating the cavity (15); and
a heating system (13, 14) for heating the elements (1, 2)
**characterized in that** the elements (1, 2) are formed in disc-shaped fashion,
the heating system has a heating radiation system (13, 14) for heating the elements (1, 2) by means of heating radiation (11, 12), and
the two membrane layers (4, 5) have an elastically deformable material having such a high thermal conductivity and surface spectral selectivity that more than 90% of the heating radiation power is absorbed.

2. Apparatus according to Patent Claim 1,
**characterized in that** the membrane layers have a metallic layer (5) or a combination of a metallic layer (5) with a membrane (4).

3. Apparatus according to Patent Claim 2,
**characterized in that** the membrane (4) has sintered graphite particles.

4. Apparatus according to Patent Claim 2,
**characterized in that** the membrane (4) has quartz or glass fibres.

5. Apparatus according to Patent Claim 2,
**characterized in that** the membrane (4) has a mixture of graphite and quartz particles.

6. Apparatus according to one of Patent Claims 2 to 5,
**characterized in that** the membrane (4) has a material adapted to the material of the disc-shaped elements (1, 2) having a similar coefficient of thermal expansion.

7. Apparatus according to one of Patent Claims 2 to 6,
**characterized in that** the metallic layer (5) has a black-chromium-coated copper.

8. Apparatus according to one of Patent Claims 2 to 6,
**characterized in that** the metallic layer (5) has a titanium-nitride-oxide-coated copper.

9. Apparatus according to one of Patent Claims 2 to 6,
**characterized in that** the metallic layer (5) has a black-chromium-coated high-grade steel.

10. Apparatus according to one of Patent Claims 1 to 9,
**characterized in that** the heating system has a multiplicity of regulable heating lamps (13) for generating uniformly distributed visible light (11, 12).

11. Apparatus according to Patent Claim 10,
**characterized in that** the heating system has a multiplicity of reflectors (14).

12. Apparatus according to one of Patent Claims 1 to 11,
**characterized in that** it is arranged for the purpose of generating furthermore increased pressures in a further pressure vessel.

13. Method for pressing together in planar fashion disc-shaped elements to be bonded, comprising the steps of:
a) preparing a pressure chamber (4, 5, 8, 9, 10) with two elastically deformable membrane layers (4, 5) arranged therein and having such high thermal conductivity and surface spectral selectivity that more than 90% of the heating radiation power is absorbed, which form a cavity (15) which can be connected to a connection system (6, 7) for evacuation;
b) arranging the disc-shaped elements (1, 2) in the cavity (15);
c) heating the disc-shaped elements (1, 2); and
d) evacuating the cavity (15) by means of the connection system (6, 7) for the purpose of generating a vacuum and for the purpose of pressing together the disc-shaped elements (1, 2).

14. Method according to Patent Claim 13,
**characterized in that**, in step a), the membrane layer used is a metallic layer (5) or a combination of a metallic layer (5) with a membrane (4).

15. Method according to Patent Claim 13 or 14,
**characterized in that**, in step c), the disc-shaped elements are heated via the membrane layers (4, 5).

16. Method according to one of Patent Claims 13 to 15,
**characterized by** a step
e) forming a more extensive external excess pressure for the pressure chamber (4, 5, 8, 9, 10) for the purpose of generating a more extensive vacuum in the cavity (15).

## Revendications

1. Dispositif pour comprimer ensemble à plat des éléments (1, 2) à relier comprenant
une chambre de pression ayant deux couches (4, 5) à membrane, une cavité (15) de réception des éléments (1, 2) et un système (6, 7) de raccordement pour mettre la cavité (15) sous vide ; et
un système (13, 14) de chauffage pour chauffer les éléments (1, 2),
**caractérisé en ce que**
les éléments (1, 2) sont en forme de disque,
le système chauffage a un système (13, 14) de rayonnement chauffant pour réchauffer les éléments (1, 2) au moyen d'un rayonnement (11, 12) chauffant et
les deux couches (4, 5) à membrane ont une matière déformable élastiquement ayant une conductivité thermique et une sélectivité spectrale en surface si grandes que plus que 90 % de la puissance du rayonnement chauffant est absorbé.

2. Dispositif suivant la revendication 1,
**caractérisé en ce que** les couches en membrane ont une couche (5) métallique ou une combinaison d'une couche (5) métallique à une membrane (4).

3. Dispositif suivant la revendication 2,
**caractérisé en ce que** la membrane (4) a des particules de graphite frittées.

4. Dispositif suivant la revendication 2,
**caractérisé en ce que** la membrane (4) a des fibres de quartz ou des fibres de verre.

5. Dispositif suivant la revendication 2,
**caractérisé en ce que** la membrane (4) a un mélange de particules de graphites et de particules de quartz.

6. Dispositif suivant l'une des revendications 2 à 5,
**caractérisé en ce que** la membrane (4) a une matière adaptée à la matière des éléments (1, 2) en forme de disque et ayant un coefficient de dilation thermique semblable.

7. Dispositif suivant l'une des revendications 2 à 6,
**caractérisé en ce que** la couche (5) métallique a du cuivre revêtu de chrome noir.

8. Dispositif suivant l'une des revendications 2 à 6,
**caractérisé en ce que** la couche (5) métallique a du cuivre revêtu d'oxynitrure de titane.

9. Dispositif suivant l'une des revendications 2 à 6,
**caractérisé en ce que** la couche (5) métallique a un acier fin revêtu de chrome noir.

10. Dispositif suivant l'une des revendications 1 à 9,
**caractérisé en ce que** le système de chauffage a une pluralité de lampes (13) de chauffage réglables pour la production de lumière (11, 12) visible répartie uniformément.

11. Dispositif suivant la revendication 10,
**caractérisé en ce que** le système de chauffage a une pluralité de réflecteurs (14).

12. Dispositif suivant l'une des revendications 1 à 11,
**caractérisé en ce qu'**il est disposé dans une autre enceinte sous pression pour la production de pressions encore plus élevées.

13. Procédé pour comprimer ensemble à plat des éléments en forme de disque à relier comprenant les stades dans lesquels :
a) on prépare une chambre (4, 5, 8, 9, 10) de pression ayant deux couches (4, 5) à membrane déformables élastiquement qui y sont disposées, d'une conductivité thermique et d'une sélectivité spectrale en surface si grandes que plus de 90 % de la puissance du rayonnement chauffant est absorbé, les deux couches formant une cavité (15) qui pour la mise sous vide peut être raccordée à un système (6, 7) de raccordement;
b) on met les éléments (1, 2) en forme de disque dans la cavité (15) ;
c) on réchauffe les éléments (1, 2) en forme de disque ; et
d) on fait le vide dans la cavité (15) au moyen du système (6, 7) de raccordement pour produire une dépression et pour comprimer ensemble les éléments (1, 2) en forme de disque.

14. Procédé suivant la revendication 13,
**caractérisé en ce qu'**au stade a) on utilise comme couche à membrane une couche (5) métallique ou une combinaison d'une couche (5) métallique à une membrane (4).

15. Procédé suivant la revendication 13 ou 14,
**caractérisé en ce qu'**au stade c) on effectue le réchauffement des éléments en forme de disque par l'intermédiaire des couches (4, 5) à membrane.

16. Procédé suivant l'une des revendications 13 à 15,
**caractérisé par** un stade
e) de constitution d'une surpression extérieure poussée pour la chambre (4, 5, 8, 9, 10) de pression afin de produire une dépression poussée dans la cavité (15).
